Europäisches Patentamt

European Patent Office

Office européen des brevets

(11) Publication number: **0 297 061 B1**

# EUROPEAN PATENT SPECIFICATION

(45) Date of publication of patent specification: **16.12.92**

(51) Int. Cl.5: **H01L 39/14**, H01B 12/16, F04B 37/04

(21) Application number: **88830268.4**

(22) Date of filing: **23.06.88**

(54) Vacuum insulated superconducting electrical conductor employing a getter device.

(30) Priority: **24.06.87 IT 2102687**

(43) Date of publication of application:
**28.12.88 Bulletin 88/52**

(45) Publication of the grant of the patent:
**16.12.92 Bulletin 92/51**

(84) Designated Contracting States:
**DE FR GB NL**

(56) References cited:
**EP-A- 0 144 524**

**REVIEW OF ELECTR. COMM. LABORATO-RIES, vol. 29, nos. 5-6, May-June 1981, pages 612-627, Tokyo, JP; M. HIKITA et al.: "Long term high-vacuum maintenance in the cryogenic envelope for superconducting tele-communication cables"**

**JAPANESE JOURNAL OF APPLIED PHYSICS, vol. 26, no. 5, 20th May 1987, pages L865-L866; Y. YAMADA et al.: "Critical current density of wire type Y-Ba-Cu oxide superconductor"**

Physical Review Letters, vol. 58, no. 25, pp. 2684-2686, P. Chaudhati et al: "Supraleitung", W. Buckel, Physik Verlag, Weinheim 1977, pp. 259 & 314.

(73) Proprietor: **SAES GETTERS S.P.A.**
**Via Gallarate, 215**
**I-20151 Milano(IT)**

(72) Inventor: **Della Porta, Paolo**
**Strada Privata delle Acacie, 13**
**Fagiana Carimate (Como)(IT)**
Inventor: **Ferrario, Bruno**
**Via B. Melzi, 146**
**Rescaldina Milano(IT)**

(74) Representative: **Adorno, Silvano et al**
**c/o SOCIETA' ITALIANA BREVETTI S.p.A. Via Carducci, 8**
**I-20123 Milano(IT)**

Rank Xerox (UK) Business Services

## Description

The present invention relates to a vacuum insulated superconducting electrical conductor employing a getter device.

The phenomenon of super-conductivity is well known. A material is said to be superconductive when its electrical resistance has been reduced to zero. For many years this phenomenon has been found, in practice, only in certain metals or alloys when their temperature has been reduced to only a few Kelvin. To cool these metals or alloys to such temperatures it has been necessary to employ liquid helium which has a boiling point of 4.2 K.

Recently new compositions of matter have been found which exhibit superconductivity at considerably higher temperatures, especially at temperatures above about 77 K. This temperature is that of liquid nitrogen which is a considerably less expensive material than liquid helium.

Although superconducting devices have been employed using liquid helium as the cooling agent, their widespread use has not been possible due to the expense of the liquid helium.

However, now that materials are available having super-conducting properties at liquid nitrogen temperatures, their use in many more applications appears to be more economical. Such uses are in the large scale transportation of electrical energy, for instance from nuclear power plants situated, for safety reasons, in isolated regions or in electromagnetic suspension railways. Whatever the new application of superconductivity opened by the use of these new materials it is still necessary to make the most economical use of the refrigerant which maintains the superconductor below the critical temperature at which its superconductivity ceases.

Vacuum insulated superconducting cables having integrated channels for coolant liquids and being operated at liquid helium temperature, are well known in the art; see e.g. Supraleitung, Grundlagen and Anwendungen, Z. Auflage; Werner Buckel, Physik Verlag, Weinheim (DE) 1977, page 259.

M. Hikita et al., Review of Electr. Comm. Laboratories 29, 612-627 (1981), Tokyo, report the use of non-evaporable getter materials for pumping and vacuum maintenance of cryogenic cables being operated at liquid helium temperature.

It is therefore an object of the present invention to provide a vacuum insulation of a superconducting electrical conductor for operation above 77 K.

Another object of the present invention is to provide a gettered vacuum insulation of a superconducting electric conductor.

These and other objects and advantages of the present invention are obtained by means of the features of claims 1 and 2 and will become apparent by reference to the following description and drawings wherein:

FIGURE 1 is a cross-sectional representation of a vacuum insulated superconducting electrical conductor of the present invention;

FIGURE 2 is a cross-sectional representation of another vacuum insulated superconducting electrical conductor of the present invention.

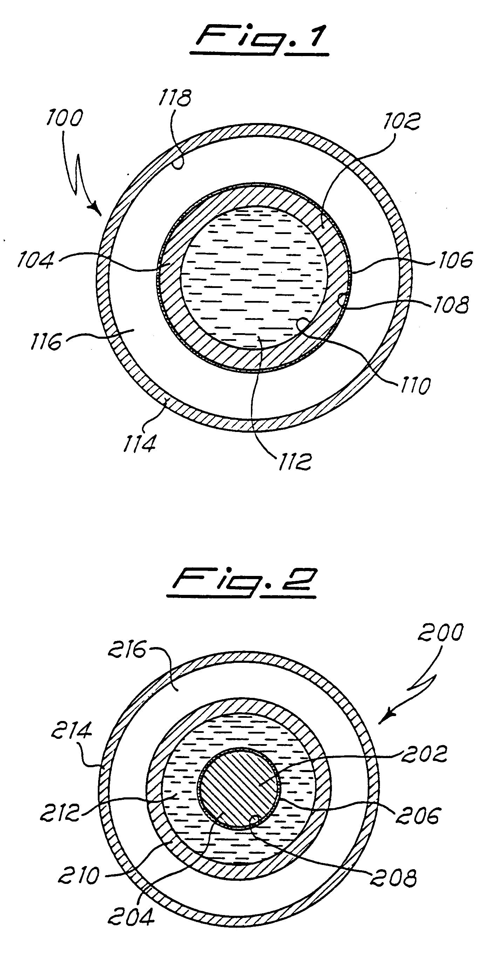

Referring now to the drawings and in particular to Fig. 1 there is shown as one embodiment of the present invention an electrical conductor 100 comprising an element 102 exhibiting superconductivity above 77K which consists of a hollow support cylinder 104 which according to the invention is of strontium titanate. A layer of superconducting material 106 is supported on the outer surface 108 of support cylinder 104. Any superconducting material which is superconducting above 77K is suitable and can be deposited upon the support cylinder outer surface 108 by any appropriate technique. According to the invention a layer of yttrium-barium-copper-oxygen can be vapour deposited onto surface 108.

The layer of superconducting material could, as an equivalent alternative, be deposited onto the inner surface 110 of hollow cylinder 104, or onto both inner and outer surfaces. Liquid nitrogen 112 is contained within and flows through hollow cylinder 104 such that element 102 is in thermal contact with the liquid nitrogen. An outer cylindrical shell 114 coaxial with support cylinder 104 defines a thermally isolating evacuated space 116 surrounding the superconducting element 102. The outer cylindrical shell 114 is of stainless steel. The pressure within evacuated space 116 should be less than 13.3 Pa and preferably less than 1.33 Pa. Contained within said evacuated space is a non-evaporable getter material capable of the permanent sorption of active gases and the reversible sorption of hydrogen. The non-evaporable getter materials is chosen from the group comprising:

(a) an alloy of zirconium with aluminium in which the weight percent of aluminium is from 5-30%;

(b) a partially sintered mixture of carbon powder or zeolite with at least one metal powder selected from the group consisting of Zr, Ta, Hf, Nb, Ti, Th and U, the carbon or zeolite powder being present in up to 30% by weight;

(c) a partially sintered mixture of

(i) a particulate Zr-Al alloy comprising 5-30 weight percent Al; balance Zr, and

(ii) at least one particulate metal powder selected from the group consisting of Zr, Ta, Hf, Nb, Ti, Th and U;

(d) a powdered alloy of Zr-V-Fe whose composition in weight percent, when plotted on a ternary composition diagram in weight percent Zr, weight percent V and weight percent Fe, lies within a polygon having as its corners the points defined by:

(i) 75% Zr - 20% V - 5% Fe

(ii) 45% Zr - 20% V - 35% Fe

(iii) 45% Zr - 50% V - 5% Fe;

(e) a partially sintered mixture of

(i) at least one particulate metal chosen from the group consisting of Ti and Zr, and

(ii) a powdered alloy of Zr-V-Fe whose composition in weight percent, when plotted on a ternary composition diagram in weight percent Zr, weight percent V and weight percent Fe, lies within a polygon having as its corners the points defined by:

(i) 75% Zr - 20% V - 5% Fe

(ii) 45% Zr - 20% V - 35% Fe

(iii) 45% Zr - 50% V - 5% Fe.

The getter material may be in the form of pills or pellets or pressure bonded to support strips of metal. It could also be electrophoretically coated to supports or to the inner surface 118 of outer cylindrical shells 114. It could also be plasma spray coated onto a surface within evacuated space 116. Evacuated space 116 may also contain one or more reflecting shields to improve the insulation properties.

Referring now to Fig. 2, there is shown an alternative embodiment of the present invention in which an electrical conductor 200 comprises an element 202 exhibiting superconductivity above 77K, which consists of a central cylindrical support core 204 which according to the invention is of strontium titanate. A layer of superconducting material 206 is supported on the outer surface 208 of said cylindrical core 204. Again the layer according to the invention is vapour deposited yttrium-barium-copper-oxygen and could be deposited in the form of a single crystal.

An inner cylindrical shell 210 of stainless steel confines liquid nitrogen 212 to a volume surrounding the central core 204. An outer cylindrical shell 214 of stainless steel surrounds a thermally insulating evacuated space 216 which surrounds the liquid nitrogen and which is separated from it by means of inner shell 210. The vacuum should have a pressure of less than 13.3 Pa and preferably less than 1.33 Pa. A non-evaporable getter material is contained within the evacuated space, as described in connection with the embodiment of Fig. 1.

## Claims

1. An electrical conductor (100) comprising:

A. a hollow support cylinder (104) of strontium titanate;

B. a vapour deposited layer (106) of yttrium-barium-copper-oxygen supported on the outer surface (108) of said hollow cylinder;

C. liquid nitrogen (112) contained within said hollow cylinder (104);

D. a thermally insulating evacuated space (116), surrounding the hollow cylinder (104), having a pressure of less than 1.33 Pa;

E. an outer cylindrical shell (114) of stainless steel; and

F. a non-evaporable getter material contained within said evacuated space (116) chosen from the group comprising:

(a) an alloy of zirconium with aluminum in which the weight percent of aluminum is from 5-30%;

(b) a partially sintered mixture of carbon powder or zeolite with at least one metal powder selected from the group consisting of Zr, Ta, Hf, Nb, Ti, Th and U, the carbon or zeolite powder being present in up to 30% by weight;

(c) a partially sintered mixture of

(i) a particulate Zr-Al alloy comprising 5-30 weight percent Al; balance Zr, and

(ii) at least one particulate metal powder selected from the group consisting of Zr, Ta, Hf, Nb, Ti, Th and U;

(d) a powdered alloy of Zr-V-Fe whose composition in weight percent, when plotted on a ternary composition diagram in weight percent Zr, weight percent V and weight percent Fe, lies within a polygon having as its corners the points defined by:

(i) 75% Zr - 20% V - 5% Fe

(ii) 45% Zr - 20% V - 35% Fe

(iii) 45% Zr - 50% V - 5% Fe;

(e) a partially sintered mixture of

(i) at least one particulate metal chosen from the group consisting of Ti and Zr, and

(ii) a powdered alloy of Zr-V-Fe whose composition in weight percent, when plotted on a ternary composition diagram in weight percent Zr, weight percent V and weight percent Fe, lies within a polygon having as its corners the points defined by:

(i) 75% Zr - 20%V - 5% Fe

(ii) 45% Zr - 20% V - 35% Fe

(iii) 45% Fe - 50% V - 5% Fe.

2. An electrical conductor (200) comprising

A. a central cylindrical support core (204) of strontium titanate;

B. a vapour deposited layer (206) of yttrium-barium-copper-oxygen supported on the outer surface (208) of said cylindrical core;

C. liquid nitrogen (212) surrounding the cylindrical core (204);

D. a thermally insulating evacuated space (216), surrounding said liquid nitrogen (212), having a pressure of less than 1.33 Pa;

E.
(i) an inner cylidrical shell (210) of stainless steel separating the liquid nitrogen (212) from said evacuated space (216); and

(ii) an outer cylindrical shell (214) of stainless steel surrounding the evacuated space (216); and

F. a non-evaporable getter material contained within said evacuated space chosen from the group comprising:

(a) an alloy of zirconium with aluminum in which the weight percent of aluminium is from 5-30%;

(b) a partially sintered mixture of carbon powder or zeolite with at least one metal powder selected from the group consisting of Zr, Ta, Hf, Nb, Ti, Th and U, the carbon or zeolite powder being present in up to 30% by weight;

(c) a partially sintered mixture of
(i) a particulate Zr-Al alloy comprising 5-30 weight percent Al; balance Zr, and

(ii) at least one particulate metal powder selected from the group consisting of Zr, Ta, Hf, Nb, Ti, Th and U;

(d) a powdered alloy of Zr-V-Fe whose composition in weight percent, when plotted on a ternary composition diagram in weight percent Zr, weight percent V and weight percent Fe, lies within the polygon having as its corners the points defined by:
(i) 75% Zr - 20% V - 5% Fe
(ii) 45% Zr - 20% V - 35% Fe
(iii) 45% Zr - 50% V - 5% Fe;

(e) a partially sintered mixture of
(i) at least one particulate metal chosen from the group consisting of Ti and Zr, and

(ii) a powdered alloy of Zr-V-Fe whose composition in weight percent, when plotted on a ternary composition diagram in weight percent Zr, weight percent V and weight percent Fe, lies within a polygon having as its corners the points defined by:
(i) 75% Zr - 20% V - 5% Fe
(ii) 45% Zr - 20% V - 35% Fe
(iii) 45% Zr - 50% V - 5% Fe.

**Patentansprüche**

**1.** Elektrischer Leiter (100), umfassend:

A. einen hohlen Trägerzylinder (104) aus Strontiumtitanat;

B. eine auf die äußere Oberfläche (108) des hohlen Zylinders aufgedampfte Schicht (106) aus Yttrium-Barium-Kupfer-Sauerstoff;

C. flüssigen Stickstoff (112), der in dem hohlen Zylinder (104) enthalten ist;

D. einen thermisch isolierenden evakuierten Raum (116), der den hohlen Zylinder (104) umgibt, mit einem Druck von weniger als 1,33 Pa;

E. eine äußere zylindrische Schale (114) aus rostfreiem Stahl; und

F. ein nicht-verdampfbares Gettermaterial, das in dem evakuierten Raum (116) enthalten ist, ausgewählt aus der Gruppe umfassend:

(a) eine Legierung aus Zirkonium mit Aluminium, in der der Gewichtsprozentanteil Aluminium 5-30 % beträgt;

(b) ein teilweise gesintertes Gemisch aus Kohlepulver oder Zeolith mit mindestens einem Metallpulver, ausgewählt aus der Gruppe Zr, Ta, Hf, Nb, Ti, Th und U, wobei das Kohle- oder Zeolithpulver in einer Menge von bis zu 30 Gew.-% zugegen ist;

(c) ein teilweise gesintertes Gemisch aus
(i) einer teilchenförmigen Zr-Al-Legierung, umfassend 5-30 Gew.-% Al; Rest Zr, und

(ii) mindestens ein teilchenförmiges Metallpulver, ausgewählt aus der Gruppe Zr, Ta, Hf, Nb, Ti Th und U;

(d) eine pulverisierte Legierung aus Zr-V-Fe, deren Zusammensetzung in Gew.-% bei Aufzeichnung in einem ternären Zusammensetzungsdiagramm in Gew.-% Zr, Gew.-% V und Gew.-% Fe innerhalb eines Polygons liegt, das als Ecken Punkte aufweist, die definiert sind durch:
(i) 75 % Zr - 20 % V - 5 % Fe
(ii) 45 % Zr - 20 % V - 35 % Fe
(iii) 45 % Zr - 50 % V - 5 % Fe;

(e) ein teilweise gesintertes Gemisch aus
(i) mindestens einem teilchenförmigen Metall, ausgewählt aus der Gruppe Ti und Zr, und

(ii) einer pulverisierten Legierung aus Zr - V - Fe, deren Zusammensetzung in Gew.-% bei Aufzeichnung in einem ternären Zusammensetzungsdiagramm in Gew.-% Zr, Gew.-% V und Gew.-% Fe innerhalb eines Polygons liegt, das als Ecken Punkte aufweist, die definiert sind durch:
(i) 75 % Zr - 20 % V - 5 % Fe
(ii) 45 % Zr - 20 % V - 35 % Fe

(iii) 45 % Zr - 50 % V - 5 % Fe.

**2.** Elektrischer Leiter (200), umfassend:

A. einen zentralen zylindrischen Trägerkern (204) aus Strontiumtitanat;

B. eine auf die äußere Oberfläche (208) des zylindrischen Kerns aufgedampfte Schicht (206) aus Yttrium-Barium-Kupfer-Sauerstoff;

C. flüssigen Stickstoff (212), der den zylindrischen Kern (204) umgibt;

D. einen thermisch isolierenden evakuierten Raum (216), der den flüssigen Stickstoff (212) umgibt, mit einem Druck von weniger als 1,33 Pa;

E.

(i) eine innere zylindrische Schale (210) aus rostfreiem Stahl, die den flüssigen Stickstoff (212) von dem evakuierten Raum (216) trennt; und

(ii) eine äußere zylindrische Schale (214) aus rostfreiem Stahl, der den evakuierten Raum (216) umgibt; und

F. ein nicht-verdampfbares Gettermaterial, das in dem evakuierten Raum enthalten ist, ausgewählt aus der Gruppe umfassend:

(a) eine Legierung aus Zirkonium mit Aluminium, in der der Gewichtsprozentanteil Aluminium 5-30 % beträgt;

(b) ein teilweise gesintertes Gemisch aus Kohlepulver oder Zeolith mit mindestens einem Metallpulver, ausgewählt aus der Gruppe Zr, Ta, Hf, Nb, Ti, Th und U, wobei das Kohle- oder Zeolithpulver in einer Menge von bis zu 30 Gew.-% zugegen ist;

(c) ein teilweise gesintertes Gemisch aus

(i) einer teilchenförmigen Zr-Al-Legierung, umfassend 5-30 Gew.-% Al; Rest Zr, und

(ii) mindestens ein teilchenförmiges Metallpulver, ausgewählt aus der Gruppe Zr, Ta, Hf, Nb, Ti Th und U;

(d) eine pulverisierte Legierung aus Zr-V-Fe, deren Zusammensetzung in Gew.-% bei Aufzeichnung in einem ternären Zusammensetzungsdiagramm in Gew.-% Zr, Gew.-% V und Gew.-% Fe innerhalb eines Polygons liegt, das als Ecken Punkte aufweist, die definiert sind durch:

(i) 75 % Zr - 20 % V - 5 % Fe
(ii) 45 % Zr - 20 % V - 35 % Fe
(iii) 45 % Zr - 50 % V - 5 % Fe;

(e) ein teilweise gesintertes Gemisch aus

(i) mindestens einem teilchenförmigen Metall, ausgewählt aus der Gruppe Ti und Zr, und

(ii) einer pulverisierten Legierung aus Zr - V - Fe, deren Zusammensetzung in Gew.-% bei Aufzeichnung in einem ternären Zusammensetzungsdiagramm in Gew.-% Zr, Gew.-% V und Gew.-% Fe innerhalb eines Polygons liegt, das als Ecken Punkte aufweist, die definiert sind durch:

(i) 75 % Zr - 20 % V - 5 % Fe
(ii) 45 % Zr - 20 % V - 35 % Fe
(iii) 45 % Zr - 50 % V - 5 % Fe.

**Revendications**

**1.** Un conducteur électrique (100) comprenant :

A. un cylindre support creux (104) en titanate de strontium :

B. une couche (106) déposée par évaporation d'yttrium-barium-cuivre-oxygène supportée sur le cylindre extérieur (108) dudit cylindre creux ;

C. de l'azote liquide (112) contenu à l'intérieur dudit cylindre creux (104) ;

D. un espace sous vide (116) isolant thermiquement entourant le cylindre creux (104), ayant une pression inférieure à 1,33 Pa ;

E. une coquille cylindrique extérieure (114) en acier inoxydable ; et

F. un matériau "getter" non évaporable contenu à l'intérieur dudit espace sous vide (116) choisi parmi le groupe comprenant :

a) un alliage de zirconium et d'aluminium dans lequel le pourcentage de l'aluminium en poids est de 5-30 ;

b) un mélange partiellement fritté de poudre de carbone ou de zéolite avec au moins une poudre de métal sélectionnée parmi le groupe comprenant Zr, Ta, Hf, Nb, Ti, Th et U, la poudre de carbone ou de zéolite étant présente à 30 % en poids.

c) un mélange partiellement fritté de

(i) un alliage Zr-Al particulier comprenant 5-30 % en poids d'Al, la quantité correspondante de Zr, et

(ii) au moins une poudre de métal particulier choisi parmi le groupe comprenant Zr, Ta, Hf, Nb, Ti, Th et U ;

d) un alliage poudreux de Zr-V-Fe dont la composition en pourcentage pondéral à l'enregistrement sur un diagramme de composition ternaire en pourcentage pondéral Zr, pourcentage pondéral V et pourcentage pondéral Fe, se situe à l'intérieur d'un polygone présentant à ses angles les points définis par :

(i) 75 % Zr - 20 % V - 5 % Fe
(ii) 45 % Zr - 20 % V - 35 % Fe
(iii) 45 % Zr - 50 % V - 5 % Fe ;

e) un mélange partiellement fritté

(i) d'au moins un métal particulier choisi parmi le groupe comprenant Ti et Zr et

(ii) un alliage poudreux de Zr-V-Fe dont la composition en pourcentage pondéral à l'enregistrement sur un diagramme de composition ternaire en pourcentage pondéral Zr, pourcentage pondéral V et pourcentage pondéral Fe, se situe à l'intérieur d'un polygone présentant à ses angles les points définis par :

(i) 75% Zr - 20% V - 5% Fe

(ii) 45% Zr - 20% V - 35% Fe

(iii) 45% Zr - 50% V - 5% Fe.

2. Un conducteur électrique (200) comprenant :

A. un noyau support cylindrique central (204) en titanate de strontium ;

B. une couche (206) déposée par évaporation d'yttrium-barium-cuivre-oxygène supportée sur la surface extérieure (208) dudit noyau central ;

C. de l'azote liquide (212) entourant le noyau cylindrique (204) ;

D. un espace sous vide (216) isolant thermiquement entourant ledit azote liquide (212), ayant une pression inférieure à 1,33 Pa ;

E.

(i) une coquille cylindrique interne (210) en acier inoxydable séparant l'azote liquide (212) dudit espace sous vide (216) ; et

(ii) une coquille cylindrique externe (214) en acier inoxydable entourant l'espace sous vide (216) ; et

F. un matériau "getter" non évaporable contenu à l'intérieur dudit espace sous vide choisi parmi le groupe comprenant :

a) un alliage de zirconium et d'aluminium dans lequel le pourcentage de l'aluminium en poids est de 5-30 ;

b) un mélange partiellement fritté de poudre de carbone ou de zéolite avec au moins une poudre de métal sélectionnée parmi le groupe comprenant Zr, Ta, Hf, Nb, Ti, Th et U, la poudre de carbone ou de zéolite étant présente à 30 % en poids.

c) un mélange partiellement fritté de

(i) un alliage Zr-Al particulier comprenant 5-30 % en poids d'Al, la quantité correspondante de Zr, et

(ii) au moins une poudre de métal particulier choisi parmi le groupe comprenant Zr, Ta, Hf, Nb, Ti, Th et U ;

d) un alliage poudreux de Zr-V-Fe dont la composition en pourcentage pondéral à l'enregistrement sur un diagramme de composition ternaire en pourcentage pondéral Zr, pourcentage pondéral V et pourcentage pondéral Fe, se situe à l'intérieur d'un polygone présentant à ses angles les points définis par :

(i) 75 % Zr - 20 % V - 5 % Fe

(ii) 45 % Zr - 20 % V - 35 % Fe

(iii) 45 % Zr - 50 % V - 5 % Fe

e) un mélange partiellement fritté

(i) d'au moins un métal particulier choisi parmi le groupe comprenant Ti et Zr et

(ii) un alliage poudreux de Zr-V-Fe dont la composition en pourcentage pondéral à l'enregistrement sur un diagramme de composition ternaire en pourcentage pondéral Zr, pourcentage pondéral V et pourcentage pondéral Fe, se situe à l'intérieur d'un polygone présentant à ses angles les points définis par :

(i) 75 % Zr - 20 % V - 5 % Fe

(ii) 45 % Zr - 20 % V - 35 % Fe

(iii) 45 % Zr - 50 % V - 5 % Fe.

## _Fig.1_

## _Fig.2_